# EUROPEAN PATENT SPECIFICATION

(11) **EP 2 433 361 B1**
(45) Date of publication and mention of the grant of the patent: **30.04.2014**
(21) Application number: 10724345.3
(22) Date of filing: 20.05.2010
(51) Int. Cl.: H03H 7/12

(54) **TV SIGNAL DISTRIBUTION FILTER HAVING PLANAR INDUCTORS**
FERNSEHSIGNALVERTEILUNGSFILTER MIT PLANAREN INDUKTOREN
FILTRE DE DISTRIBUTION DE SIGNAUX TV ÉQUIPÉ D'INDUCTEURS PLANS

(30) Priority: 20.05.2009 EP 09160840
(43) Date of publication of application: 28.03.2012
(73) Proprietor: Unitron, 8970 Poperinge (BE)
(72) Inventor: DELEU, Stephen, B-9080 Beervelde (BE); VESELY, Jan, 530 12 Pardubice (CZ); PARDUBICKY, Vojtech, 285 04 Nepomerice (CZ); KRAL, Jan, 530 03 Pardubice (CZ)
(74) Representative: Sarlet, Steven Renaat Irène
(86) International application number: PCT/EP2010/056958
(87) International publication number: WO 2010/139562

(56) References cited:
- EP-A2- 1 184 977
- WO-A1-01/24362
- GB-A- 1 271 441
- JP-A- 6 140 863
- JP-A- 11 284 472
- US-A- 3 718 874
- US-A1- 2002 186 099
- US-B1- 6 370 033
- KAGEYAMA K ET AL: "TUNABLE ACTIVE FILTERS HAVING MULTILAYER STRUCTURE USING LTCC" 2001 IEEE MTT-S INTERNATIONAL MICROWAVE SYMPOSIUM DIGEST.(IMS 2001). PHOENIX, AZ, MAY 20 - 25, 2001; [IEEE MTT-S INTERNATIONAL MICROWAVE SYMPOSIUM], NEW YORK, NY : IEEE, US LNKD- DOI:10.1109/MWSYM.2001.967174, 20 May 2001 (2001-05-20), pages 1445-1448, XP001067492 ISBN: 978-0-7803-6538-4

## Description

### Technical field

The present invention relates generally to filters in programmable electronic TV signal distribution devices that selectively process TV signals received from antenna or cable and deliver a processed signal which is distributed over a plurality of TV sets.

### Background art

In TV reception, a selective processing of the received signals is required. The desired signals with known frequencies have to be passed, while the others have to be suppressed. This has been realised by the electronic circuits called filters, in most cases band-pass filters.

An analogue circuit solution of the band-pass filter consists at least of one inductor and one capacitor (frequency tuning circuit), more often different combinations of more inductors and capacitors. The simplest filter of the first generation had both a fixed centre frequency and a fixed bandwidth. A corresponding circuit has also all fixed inductors and capacitors within its structure. Such a solution was very cheap but did not allow simple retuning if needed.

The second filter generation brought circuits with tuneable band-pass centre frequency while the bandwidth was still constant (e.g. GB2272341). Such a solution was sufficient for the late analogue TV transmission characterized by a fixed bandwidth of the TV channels. The filter circuit can be retuned generally by the change of either inductor or capacitor value. The most suitable components for retuning are varicap diodes which can be used as a voltage-controlled capacitor if they are operated reverse-biased. It is why the second filter generation consisted not only of fixed inductors and capacitors but also of varicap diodes. Varicap diodes were employed here as the element which enabled electronically (by the usage of an accompanying digital control part) retuning of the filter.

The newest digital transmission concept brought a requirement to retune in the filters both the band-pass centre frequency and bandwidth. The reason is that the TV channels are broadcasted in groups - clusters of analogue and digital channels. The third filter generation solves this by a bigger complexity of the filter circuits. The varicap diodes are used here not only to retune a centre frequency of the band-pass filters but also to change a coupling between the tuning circuits. An example of such device can be found in the Unitron N.V. product range and has been described in EP1794883.

A crucial parameter in all the three generations of the filters is the selectivity. It defines how much the practical filter differs from the ideal one which has a completely flat pass band and a zero roll-off (all frequencies outside the desired frequency range are completely suppressed). To achieve the best selectivity, the filter circuits have been only equipped with aerial coils which have the highest quality factor for the practical usage.

A disadvantage of using aerial coils is that the shape of all used coils of the frequency tuning circuits must be set. Further, between some of the filter coils one even has to set very accurately the distance (filter coupling factor). As a result, this is typically performed by manually shaping the coils to reach a target characteristic on the measurement equipment (network analyser), which requires highly skilled people. Optionally a programmed robot can be used to do the shaping automatically. In both cases, the process is however time consuming and needs expensive machinery. So even though technology can be used to reach a high quality factor of the coils in the filters, the fabrication process is very complex and leads to a high cost price of the product. Furthermore, increasing the production capacity is not easy since one has to find highly skilled person or invest in expensive machinery.

GB1271441 discloses a tunable passband filter used in a TV tuner and having two resonant circuits. Each resonant circuit is made of a strip line in series with an inductor and a tunable capacitor. A variable inductive coupling is provided by a coupling means between the strip lines.

### Disclosure of the invention

It is an aim of the present invention to provide a TV signal distribution filter device which can be manufactured at a reduced cost while still obtaining a high quality factor.

This aim is achieved according to the invention with a TV signal distribution filter device showing the technical characteristics of the first claim.

Thereto, the present invention provides a TV signal distribution filter device having at least one tuneable band-pass filter circuit, wherein the inductors are provided as planar inductors instead of the aerial coils used in the prior art. The planar inductors are mechanically fixed and embedded in a dielectric environment. The advantage of planar inductors is that they have a fixed and easily reproducible morphology, so the filter production flow can be made much faster and economical. Especially since there is no longer a need for a manual tuning step.

Another advantage of the use of planar inductors is that they can be easily integrated in a Surface Mount Technology (SMT) production process.

Another advantage is that there is no longer a need to use separated varicap diode voltages for different tuning circuits and separated voltages for coupling varicap diodes between tuning circuits within one filter. With the aerial coils used in the prior art there were big tolerances on the parameters (coil shape and through hole soldering), whereas the planar inductors used according to the invention are highly reproducible.

Another advantage is also that the radiation of the aerial coils is cancelled in the filter device, which had to be carefully eliminated in the prior art by a shielding especially in the case of multiple filters. As the planar inductors which are used according to the invention are embedded in a dielectric environment, the risk of parasitic feedback and signal leakage between neighbour filters is minimised without further shielding.

In preferred embodiments of the invention, the planar inductors are provided in a single conductive layer of the dielectric environment, which is in this case preferably a single sided printed circuit board (PCB) substrate. Such a low cost solution enables to integrate planar inductors with other components of the TV signal distribution filter to a common unit, easy to produce and at low cost.

In preferred embodiments of the invention, the planar inductors are provided in different conductive layers of the dielectric environment, which is in this case preferably a double-sided or multilayer PCB substrate. Such a solution can significantly improve the selectivity of the filter. Preferably, the first and second inductors overlap each other at least partly (i.e. are located partly above each other seen in a direction perpendicular to the planes of the planar inductors).

In preferred embodiments of the invention, the device comprises a plurality of tuneable band-pass filter circuits connected in a cascade. With two or more band-pass filtering circuits in series, a better selectivity of the total filtering can be achieved. Such a cascaded section can be either provided by a simple joining of the filter circuits or can be also realised with intermediate matching circuits or amplifiers, if necessary.

Preferably, in such a case, the planar inductors of the cascaded tuneable filter circuits have a predetermined morphology, such that synchronised relations exist between the tuning voltage and the respective filtering parameters in each of the cascaded tuneable filter circuits. This means that the morphology (the design of the physical structure) of the planar inductors of the different filter circuits in the cascade is optimised with respect to each other, such that the relation between the tuning voltage and the respective filtering parameter (e.g. centre frequency, cut-off frequency, coupling, ...) in a first stage of the cascade is equal to or proportional to the relation between the tuning voltage and the same filtering parameter in a second stage of the cascade. In this way a common voltage can be used for controlling the varicap diodes used in tuning circuits of two or more filters in series.

Depending on the practical tolerance of the dielectric environment, different options are possible. A first being the integration of the complete circuitry on 1 PCB, a second being the implementation of each filter on a separate PCB, a third being the implementation of each inductor or combination of inductors on a separate PCB.

### Brief description of the drawings

The invention will be further explained by means of the following description and the appended figures.
Figure 1 schematically shows a prior art TV signal distribution band-pass filter with aerial coils.
Figure 2 schematically shows a TV signal distribution band-pass filter having planar inductors according to the present invention.
Figure 3 schematically shows an embodiment of the invention where the planar inductors have been realised by an etched conductive layer on a single sided PCB substrate.
Figure 4 schematically shows an embodiment of the invention where the planar inductors have been realised by an etched conductive layer on a double-sided PCB substrate.
Figure 5 schematically shows a preferred embodiment of a TV signal distribution band-pass filter according to the present invention.
Figure 6 schematically shows two tuneable filter circuits connected in a cascade for achieving better selectivity of the total filtering. The cascaded section has been provided here by an intermediate amplifier.

### Modes for currying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

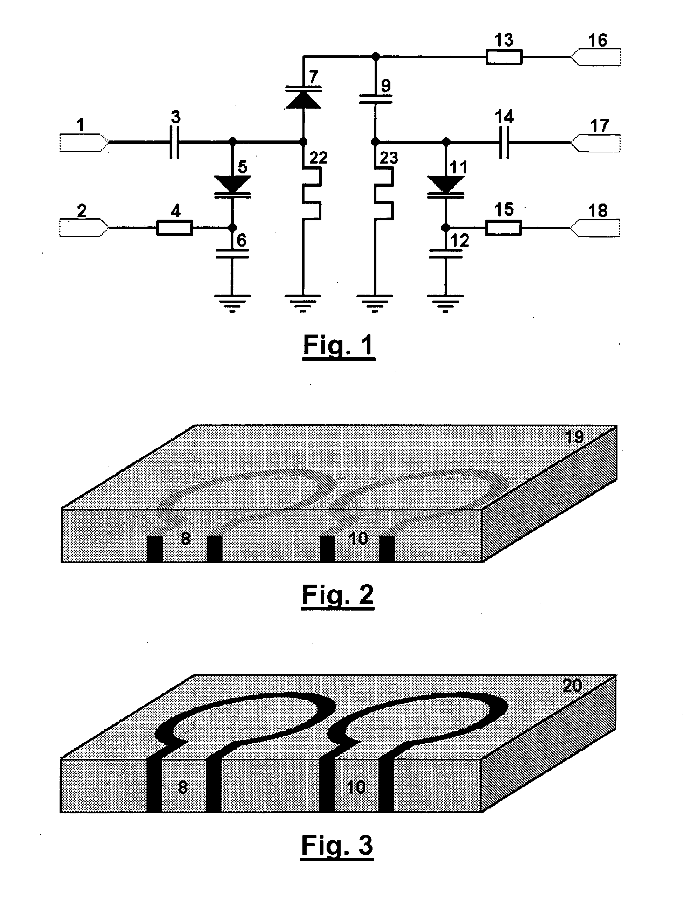

Figure 1 shows a typical prior art TV signal distribution band-pass filter with aerial coils 22, 23. It is an electronically tuned band-pass filter with aerial coils and varicap diodes which enable to set both band-pass centre frequency and bandwidth by the voltages. The circuit has a signal input 1, has a signal output 17, has pins 2 and 18 for providing a frequency tuning voltage and has a pin 16 for providing an external bandwidth setting voltage. The filter circuit comprises an input capacitor 3 and an output capacitor 14 for DC blocking the incoming and outgoing signals. Also capacitors 6, 9 and 12 block DC voltages from the varicap diodes 5, 7 and 11. The filter circuit further comprises resistors 4, 13 and 15 for the DC biasing of varicap diodes 5, 7 and 11. The filter circuit comprises two tuning circuits; the first comprises capacitor 6, varicap diode 5 and coil 22. The second tuning circuit comprises coil 23, varicap diode 11 and capacitor 12. These tuning circuits are tuned by tuning voltages entering via pins 2 and 18 to reach a required band-pass centre frequency of the whole filter. An external voltage on the pin 16 sets a coupling between the tuning circuits by changing the varicap diode 7 capacitance. In this way the frequency bandwidth of the filtering is controlled.

The coils 22 and 23 in the typical prior art TV signal distribution band-pass filter have an aerial design. As the varicap diodes have limited minimum and maximum voltage, the fabrication process has to ensure that the coils 22 and 23 in the filter have a shape within some mechanical limits (determines the frequency) and also that their relative distance has only a small tolerance (determines the bandwidth). Such a process can make the device very expensive.

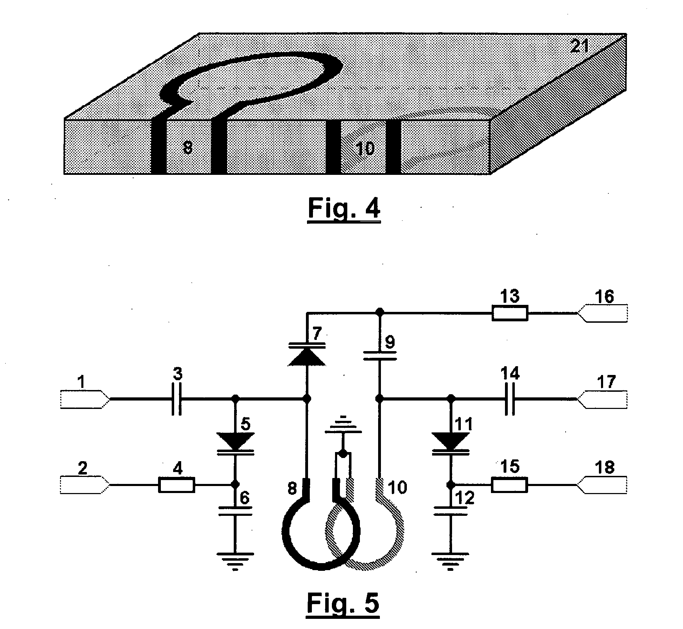

Figure 5 shows a TV signal distribution band-pass filter according to the invention. The filter circuit has the same components as the prior art circuit of figure 1, except for the inductors 8, 10, which are here planar inductors, mechanically fixed and embedded in a dielectric environment. This gives them an accurate and reproducible shape (inductance) and cross distance (coupling). In this way the necessity of the additional shaping/tuning of the coils during the production flow is eliminated. If sufficient care is taken in designing the shape and distance of the inductors and in the accuracy of the lithography process, the resulting device can become highly reproducible.

Figures 2-4 show alternative embodiments for the planar inductors 8, 10 of a band-pass filter device according to Fig. 5. In Fig. 2, the inductors have been defined by a lithography process in a single conductive layer embedded in a dielectric substrate 19. As a result, unintended radiation to other inductors is much smaller in comparison with the aerial coils of the prior art. In this way a shielding system in the device can be reduced or even eliminated.

In the embodiment of Fig. 3, the planar inductors 8 and 10 have been manufactured by etching a conductive layer on a single sided PCB substrate surface 20. Such a way of the fabrication is fully compatible with the other assembling technology and can make the production very economical.

The inductors 8 and 10 can also be placed in different conductive layers of a double-sided or even a multilayer PCB substrate 21, as shown in the Fig. 4. Such a solution has the advantage of a potential overlapping of the coils if needed comparing to the above mentioned single sided PCB solution. Such a morphology enables to increase a coupling factor and can significantly improve a selectivity of the filter as well. Overlapping the coils also makes the filter less sensitive for the external interferences. Last but not least, the overlapped morphology of the coils consumes less space. Extra conductive layers on the substrate of multilayer PCBs can be used for additional shielding which can decrease the required coupling between coils of the same filter and unwanted radiation to the neighbourhood, and can also decrease an external interference sensitivity.

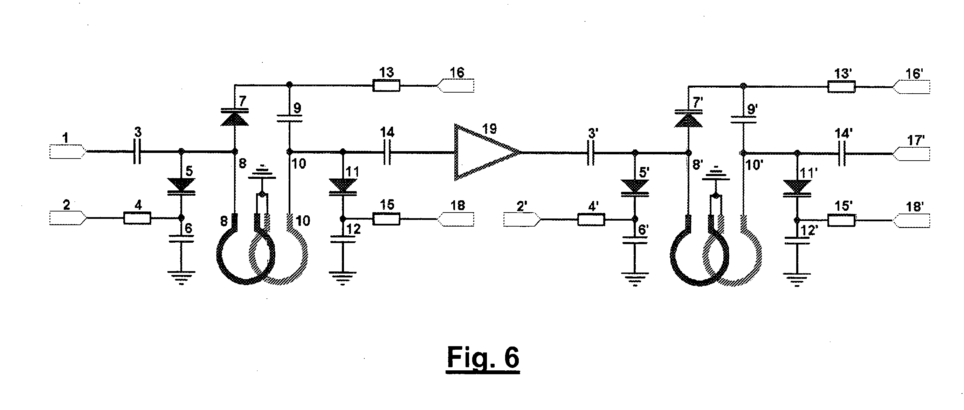

It is also possible to use more than one filter circuit in the signal path if the filter selectivity is insufficient. To do so, it could be needed to use an intermediate impedance matching and/or signal level amplification circuits. Figure 6 shows an example of such a cascade connection of two tuneable filter circuits. They are both electronically tuned band-pass filters with planar inductors 8, 10, 8', 10' and varicap diodes 5, 7, 11, 5', 7', 11' and associated voltage nodes 2, 16, 18, 2', 16', 18' which enable to set both band-pass centre frequency and bandwidth in both stages of the cascade. The circuit has a signal input 1 and has a signal output 17'. The amplifier 19 in between the tuneable filter circuits compensates a signal loss caused by the filtering and can even bring a positive gain of the total circuit. The functionality of the other components of the first stage is the same as has been described by means of figure 1. The like components of the second stage having the single quoted reference numbers also have an analogical purpose and therefore need no further description here.

Especially in the case of using more filters in series it can be very useful to ensure synchronised controlling of as much as possible frequency voltages and as much as possible bandwidth voltages. This can be achieved by the careful design of morphology of all planar inductors and distances (overlapping) between them. In the best case, for a band-pass filter, the full cascade of the filters can be fully controlled by only two voltages, which according to the embodiment of figure 6 would mean that the voltage nodes 2, 2', 18 and 18' receive a first voltage and the voltage nodes 16, 16' receive a second voltage. The first voltage controls the centre frequency and the second voltage controls the bandwidth of the frequency filtering.

In the figures, the planar inductors are shown as circular single winding elements. In alternative embodiments, the planar inductors can also be rectangular, oval or other shapes and can have multiple windings, possibly also on different conductor planes of the dielectric environment.

In the figures and in the description above, varicap diodes have been used as the tuneable capacitive components which are controlled by the tuning voltages for setting the respective filtering parameter (e.g. centre frequency or bandwidth). In alternative embodiments, other tuneable capacitive components can be used as well according to the invention, such as for example voltage controlled switched capacitor banks.

The dielectric environment can be composed of a single dielectric material or different dielectric materials. For example, in the embodiment shown in figure 2, the dielectric material above the inductors can be a different material than that below the coils. Alternatively, each inductor can be embedded in a different dielectric material. Air can form one of the materials of the dielectric environment, like in the embodiments shown in figures 3 and 4.

## Claims

1. TV signal distribution filter device comprising at least one tuneable band-pass filter circuit, each tuneable band-pass filter circuit having a signal input (1) for receiving a TV signal, a signal output (17) for delivering a filtered TV signal which is distributed over a plurality of TV sets, and a plurality of components connected in a predetermined configuration between the signal input and the signal output and together being provided for filtering the received TV signal to the filtered TV signal, said plurality of components comprising:
- a first tuning circuit comprising a first inductor (8) connected to a first tuneable capacitive component (5); and
- a second tuning circuit comprising a second inductor (10) connected to a second tuneable capacitive component (11);
the first and second tuning circuits being each connected to a voltage node (2, 18) which is provided for receiving a tuning voltage for tuning the tuneable capacitive component and thereby together setting a band-pass centre frequency of the tuneable filter circuit, **characterised in that** the first and second Inductors are planar inductors which are provided In at least one conductive layer of a printed circuit board substrate (19; 20; 21) and are electro-magnetically coupled with each other.

2. TV signal distribution filter device according to claim 1, **characterised in that** the first and second planar inductors are provided in a single conductive layer of the printed circuit board substrate (19; 20).

3. TV signal distribution filter device according to claim 2, **characterised in that** the printed circuit board substrate is a single sided printed circuit board substrate (20).

4. TV signal distribution filter device according to claim 1, **characterised in that** the first and second planar inductors are provided in different conductive layers of the printed circuit board substrate (21).

5. TV signal distribution filter device according to claim 4, **characterised in that** the printed circuit board substrate is a double-sided or multilayer printed circuit board substrate (21).

6. TV signal distribution filter device according to claim 4 or 5, **characterised in that** the first and second inductors overlap.

7. TV signal distribution filter device according to any one of the previous claims, **characterised in that** the device comprises a plurality of said tuneable band-pass filter circuits connected in a cascade.

8. TV signal distribution filter device according to claim 7, **characterised in that** the planar inductors of the cascaded tuneable filter circuits have a predetermined morphology, such that synchronised relations exist between the tuning voltages and the respective filtering parameters in each of the cascaded tuneable filter circuits.

9. TV signal distribution filter device according to any one of the previous claims, **characterised in that** the tuneable capacitive components are varicap diodes. ,

10. TV signal distribution filter device according to any one of the previous claims, **characterised in that** each band-pass filter circuit comprises:
- a first varicap diode (5) and a first fixed capacitor (6) in parallel to the first inductor (8), together forming a first tuning circuit;
- a second varicap diode (11) and a second fixed capacitor (12) in parallel to the second inductor (10) forming a second tuning circuit, the first and second tuning circuits together setting a band-pass centre frequency of the tuneable filter circuit; and
- a third varicap diode (7) and a third fixed capacitor (9) forming a coupling between the first inductor (8) and the second inductor (10), the coupling setting a bandwidth of the tuneable filter circuit.

## Patentansprüche

1. Fernsehsignal-Verteilungsfiltervorrichtung, welche mindestens eine einstellbare Bandpassfilterschaltung umfasst, wobei jede einstellbare Bandpassfilterschaltung einen Signaleingang (1) zum Empfangen eines Fernsehsignals, einen Signalausgang (17) zum Abgeben eines gefilterten Fernsehsignals, welches über mehrere Fernsehgeräte verteilt wird, und mehrere Komponenten aufweist, die in einer vorgegebenen Konfiguration zwischen dem Signaleingang und dem Signalausgang verbunden sind und zusammen zum Filtern des empfangenen Fernsehsignals zu dem gefilterten Fernsehsignal bereitgestellt werden, wobei die mehreren Komponenten das Folgende umfassen:
- eine erste Einstellungsschaltung, welche einen ersten Induktor (8) umfasst, der mit einer ersten einstellbaren kapazitiven Komponente (5) verbunden ist; und
- eine zweite Einstellungsschaltung, welche einen zweiten Induktor (10) umfasst, der mit einer ersten einstellbaren kapazitiven Komponente (11) verbunden ist;
wobei die erste und zweite einstellbare Schaltung jeweils mit einem Spannungsknoten (2, 18) verbunden sind, welcher zum Empfangen einer Einstellungsspannung zum Einstellen der einstellbaren kapazitiven Komponente bereitgestellt ist, und dadurch zusammen eine Bandpass-Mittelfrequenz der einstellbaren Filterschaltung einstellen, **dadurch gekennzeichnet, dass** der erste und zweite Induktor planare Induktoren sind, welche in mindestens einer leitenden Schicht eines Leiterplattensubstrats (19; 20; 21) bereitgestellt sind und elektromagnetisch miteinander verbunden sind.

2. Fernsehsignal-Verteilungsfiltervorrichtung nach Anspruch 1, **dadurch gekennzeichnet, dass** der erste und zweite planare Induktor in einer einzigen leitenden Schicht des Leiterplattensubstrats (19; 20) bereitgestellt werden.

3. Fernsehsignal-Verteilungsfiltervorrichtung nach Anspruch 2, **dadurch gekennzeichnet, dass** das Leiterplattensubstrat ein einseitiges Leiterplattensubstrat (20) ist.

4. Fernsehsignal-Verteilungsfiltervorrichtung nach Anspruch 1, **dadurch gekennzeichnet, dass** der erste und zweite planare Induktor in verschiedenen leitenden Schichten des Leiterplattensubstrats (21) bereitgestellt werden.

5. Fernsehsignal-Verteilungsfiltervorrichtung nach Anspruch 4, **dadurch gekennzeichnet, dass** das Leiterplattensubstrat ein doppelseitiges oder mehrschichtiges Leiterplattensubstrat (21) ist.

6. Fernsehsignal-Verteilungsfiltervorrichtung nach Anspruch 4 oder 5, **dadurch gekennzeichnet, dass** sich der erste und zweite Induktor überlappen.

7. Fernsehsignal-Verteilungsfiltervorrichtung nach einem der vorhergehenden Ansprüche, **dadurch gekennzeichnet, dass** die Vorrichtung mehrere der einstellbaren Bandpassfilterschaltungen umfasst, die in Reihe geschaltet sind.

8. Fernsehsignal-Verteilungsfiltervorrichtung nach Anspruch 7, **dadurch gekennzeichnet, dass** die planaren Induktoren der in Reihe geschalteten einstellbaren Filterschaltungen eine vorgegebene Morphologie aufweisen, so dass zwischen den Einstellungsspannungen und den entsprechenden Filterparametern in jeder der in Reihe geschalteten Filterschaltungen synchronisierte Beziehungen vorliegen.

9. Fernsehsignal-Verteilungsfiltervorrichtung nach einem der vorhergehenden Ansprüche, **dadurch gekennzeichnet, dass** die einstellbaren kapazitiven Komponenten Varaktordioden sind.

10. Fernsehsignal-Verteilungsfiltervorrichtung nach einem der vorhergehenden Ansprüche, **dadurch gekennzeichnet, dass** jede Bandpassfilterschaltung das Folgende umfasst:
- eine erste Varaktordiode (5) und einen ersten festen Kondensator (6) in Parallelschaltung zu dem ersten Induktor (8), welche zusammen eine erste Einstellungsschaltung bilden;
- eine zweite Varaktordiode (11) und einen zweiten festen Kondensator (12) in Parallelschaltung zu dem zweiten Induktor (10), welche eine zweite Einstellungsschaltung bilden, wobei die erste und zweite Einstellungsschaltung zusammen eine Bandpass-Mittelfrequenz der einstellbaren Filterschaltung einstellen; und
- eine dritte Varaktordiode (7) und einen dritten festen Kondensator (9), welche eine Kopplung zwischen dem ersten Induktor (8) und dem zweiten Induktor (10) bilden, wobei durch die Kopplung eine Bandbreite der einstellbaren Filterschaltung eingestellt wird.

## Revendications

1. Dispositif filtre de distribution de signaux TV comprenant au moins un circuit de filtre passe-bande accordable, chaque circuit de filtre passe-bande accordable ayant une entrée de signaux (1) pour recevoir un signal TV, une sortie de signaux (17) pour délivrer un signal TV filtré qui est distribué à une pluralité de téléviseurs, et une pluralité de composants connectés dans une configuration prédéterminée entre l'entrée de signaux et la sortie de signaux et étant prévus ensemble pour filtrer le signal TV reçu pour produire le signal filtré, ladite pluralité de composants comprenant :
- au moins un premier inducteur (8) comprenant un premier circuit d'accord, connecté à un premier composant capacitif accordable (5) ; et
- au moins un deuxième inducteur (10) comprenant un deuxième circuit d'accord, connecté à un deuxième composant capacitif accordable (11) ;
les premier et deuxième circuits d'accord étant connectés chacun à un noeud de tension (2, 18) qui est prévu pour recevoir une tension de syntonisation pour accorder le composant capacitif accordable et réglant ainsi ensemble une fréquence centrale passe-bande du circuit de filtre accordable, **caractérisé en ce que** les premier et deuxième inducteurs sont des inducteurs plans qui sont prévus dans au moins une couche conductrice d'un substrat (19 ; 20 ; 21) de carte de circuits imprimés et sont couplés électro-magnétiquement l'un à l'autre.

2. Dispositif filtre de distribution de signaux TV selon la revendication 1, **caractérisé en ce que** les premier et deuxième inducteurs plans sont prévus dans une seule couche conductrice du substrat (19 ; 20) de carte de circuits imprimés.

3. Dispositif filtre de distribution de signaux TV selon la revendication 2, **caractérisé en ce que** le substrat de carte de circuits imprimés est un substrat (20) de carte de circuits imprimés monoface.

4. Dispositif filtre de distribution de signaux TV selon la revendication 1, **caractérisé en ce que** les premier et deuxième inducteurs plans sont prévus dans des couches conductrices différentes du substrat (21) de carte de circuits imprimés.

5. Dispositif filtre de distribution de signaux TV selon la revendication 4, **caractérisé en ce que** le substrat de carte de circuits imprimés est un substrat (21) de carte de circuits imprimés double face ou multicouche.

6. Dispositif filtre de distribution de signaux TV selon la revendication 4 ou 5, **caractérisé en ce que** les premier et deuxième inducteurs se chevauchent.

7. Dispositif filtre de distribution de signaux TV selon l'une quelconques des revendications précédentes, **caractérisé en ce que** le dispositif comprend une pluralité desdits circuits de filtre passe-bande accordable connectés en une cascade.

8. Dispositif filtre de distribution de signaux TV selon la revendication 7, **caractérisé en ce que** les inducteurs plans des circuits de filtre accordable en cascade ont une morphologie prédéterminée de sorte qu'il y a des relations synchronisées entre les tensions de syntonisation et les paramètres de filtrage respectifs dans chacun des circuits de filtre accordable en cascade.

9. Dispositif filtre de distribution de signaux TV selon l'une quelconques des revendications précédentes, **caractérisé en ce que** les composants capacitifs accordables sont des diodes à capacité variable.

10. Dispositif filtre de distribution de signaux TV selon l'une quelconques des revendications précédentes, caractérisé en ce chaque circuit de filtre passe-bande comprend :
- une première diode à capacité variable (5) et un premier condensateur (6) fixe en parallèle au premier inducteur (8), formant ensemble un premier circuit d'accord ;
- une deuxième diode à capacité variable (11) et un deuxième condensateur (12) fixe en parallèle au deuxième inducteur (10), formant ensemble un deuxième circuit d'accord, les premier et deuxième circuits d'accord établissant ensemble une fréquence centrale passe-bande du circuit de filtre accordable ; et
- une troisième diode à capacité variable (7) et un troisième condensateur (9) fixe formant un couplage entre le premier inducteur (8) et le deuxième inducteur (10), le couplage établissant une largeur de bande du circuit de filtre accordable.
